# FASCICULE DE BREVET EUROPEEN

(11) **EP 3 058 591 B1**
(45) Date de publication et mention de la délivrance du brevet: **18.11.2020**
(21) Numéro de dépôt: 13795548.0
(22) Date de dépôt: 18.10.2013
(51) Int. Cl.: H01L 23/367, H01L 23/373

(54) **SUPPORT POUR COMPOSANTS ÉLECTRONIQUES DE PUISSANCE, MODULE DE PUISSANCE DOTÉ D'UN TEL SUPPORT, ET PROCÉDÉ DE FABRICATION CORRESPONDANT**
TRÄGER FÜR ELEKTRONISCHE LEISTUNGSKOMPONENTEN, LEISTUNGSMODUL MIT SOLCH EINEM TRÄGER UND ZUGEHÖRIGES HERSTELLUNGSVERFAHREN
SUPPORT FOR ELECTRONIC POWER COMPONENTS, POWER MODULE PROVIDED WITH SUCH A SUPPORT, AND CORRESPONDING PRODUCTION METHOD

(43) Date de publication de la demande: 24.08.2016
(73) Titulaire: Griset, 92522 Neuilly Sur Seine (FR); Laboratoire National de Metrologie et d'Essais, 75724 Paris Cedex 15 (FR); Association pour la Recherche et le Développement des Méthodes et Processus Industriels (ARMINES), 75272 Paris Cedex 06 (FR)
(72) Inventeur: IDRAC, Jonathan, F-78360 Montesson (FR); KAABI, Abderrahmen, Montréal (Quebec) H01L 3J1 (CA); BIENVENU, Yves, F-91000 Evry (FR); PIERRE, Bertrand, F-78590 Noisy Le Roy (FR)
(74) Mandataire: Casalonga
(86) Numéro de dépôt international: PCT/FR2013/052493
(87) Numéro de publication internationale: WO 2015/055899

(56) Documents cités:
- EP-A2- 2 012 355
- FR-A1- 2 511 193
- FR-A1- 2 951 020
- JP-A- H05 109 947
- US-A1- 2001 038 140
- US-A1- 2004 016 748
- US-A1- 2004 041 244
- US-A1- 2004 142 202
- US-A1- 2005 035 447
- US-A1- 2011 045 300
- US-A1- 2012 043 875
- US-B1- 6 317 331

## Description

L'invention concerne, de manière générale, le domaine de l'électronique de puissance, et concerne plus particulièrement un support pour composants électroniques de puissance.

L'invention se rapporte également à un module d'électronique de puissance et à un procédé de fabrication d'un tel support.

Les modules de puissance sont des modules électroniques qui sont notamment utilisés pour assurer la commande de charges de forte puissance, par exemple pour la gestion de moteurs électriques.

Leur utilisation tend à se développer, par exemple à bord des aéronefs ou des véhicules automobiles.

Les modules électroniques de puissance comportent des composants électroniques de puissance, en particulier des puces électroniques, réalisés en silicium ou en un autre semi-conducteur tel que le Nitrure de Gallium, le Carbure de Silicium,..., qui sont montés sur un support qui assure notamment le refroidissement des composants.

L'une des principales sources de défaillance des composants électroniques de puissance est liée à la différence de dilatation thermique entre d'une part le support, généralement réalisé en cuivre, et d'autre part la puce électronique dont le coefficient de dilatation est généralement de l'ordre du tiers de celui du cuivre. L'accroissement permanent de la puissance et de la fréquence de fonctionnement des composants électroniques provoque de plus en plus de pertes thermiques qui augmentent la température de travail du composant électronique de puissance et du support. La nature métallurgique distincte du substrat et du composant a pour conséquence un comportement thermique différent vis-à-vis de la chaleur. Par conséquent, l'élévation de la température engendre des contraintes de cisaillement considérables dans la zone de liaison qui peuvent provoquer la dégradation, voire la destruction des assemblages puce/support.

Pour le bon fonctionnement de la puce en silicium comme pour sa longévité, il est essentiel d'évacuer un maximum de chaleur. Bien que le cuivre assure pleinement sa fonction de conducteur de chaleur, son coefficient de dilatation linéique est plus de trois fois supérieur à celui du silicium ou des autres semi-conducteurs actuels, ce qui n'est pas favorable à la liaison puce/support.

Ainsi, il est autant recherché un support possédant de bonnes conductivités thermique voire électrique, qu'un coefficient de dilatation linéique faible et voisin de celui du verre ou du silicium dans le plan du support. Or, ces deux propriétés sont naturellement antinomiques. En effet, en dehors du diamant, aucun matériau de la classification périodique des éléments ne permet de répondre à ces deux propriétés de conduction de chaleur et de faible dilatation.

C'est pourquoi, d'autres supports ont été développés.

Il a ainsi été proposé d'utiliser des supports à base d'un matériau composite à matrice métallique (dont l'abréviation est « CMM »). Par exemple, il a été proposé d'utiliser l'Al-SiC [2, 3, 6], le Cu-SiC [5], le Cu-Diamant [1, 2, 4], le Cu-C (fibres) [1, 3, 8], etc. Ces matériaux présentent une forte complexité de fabrication associée à un prix de revient élevé. En général, la pièce réalisée doit en outre présenter les côtes finales du support puisque l'usinage est quasi-impossible d'où des fabrications à l'unité, onéreuses en investissement car peu productives.

US2004/016748 concerne un système de radiateur, un procédé de rayonnement et un tampon thermique qui éliminent les contraintes thermiques générées lorsque de la chaleur est transmise entre des corps à température élevée et des récepteurs.

Des supports colaminés comprenant deux couches externes en métal conducteur de la chaleur disposées de part et d'autre d'une couche interne en matériau à dilatabilité thermique limitée sont également employés. Des exemples de support colaminés ont été réalisés à partir des couches Cu/Mo/Cu [2, 3, 7], Cu/Alliages Mo-Cu/Cu [2, 3, 7] ou Cu/alliages Fe-Ni à dilatation contrôlée/Cu [9]. Bien qu'ils présentent un coefficient de dilatation faible, leur conductivité thermique dans le sens d'évacuation de la chaleur est, cependant, insuffisante. En effet, la couche interne constitue une barrière thermique. Tel est en particulier le cas, par exemple, de l'Invar® dont la conductivité thermique est vingt fois plus faible que celle du cuivre.

Il a également été proposé d'utiliser un matériau composite multicouche comprenant une couche interne en Invar® et des couches externes en matériau conducteur de la chaleur, par exemple en cuivre ou en alliage de cuivre, disposées de part et d'autre de la couche interne et reliées entre elles par des puits, également réalisés en matériau conducteur de la chaleur et qui sont agencés dans la couche interne, de manière à générer des ponts thermiques permettant d'évacuer la chaleur à travers la couche interne à faible coefficient de dilatation thermique.

On pourra à cet égard se référer au document FR 2951 020 qui décrit un tel matériau composite multicouche.

Un tel matériau est réalisé par colaminage des couches interne et externes.

Il a été constaté qu'un tel matériau, s'il permet d'obtenir le meilleur compromis entre la conductivité thermique et le coefficient de dilatation linéique, présente néanmoins un inconvénient majeur qui nuit à son utilisation en tant que support de module électronique de puissance notamment pour l'automobile, le domaine ferroviaire, le domaine de l'avionique et des machines industrielles.

En effet, bien que les fortes pressions exercées lors du colaminage et les déformations plastiques consécutives permettent d'obtenir des liaisons atomiques entre les surfaces parallèles au plan de laminage et en regard des couches interne et externes et une densification des micro aspérités dans le plan de contact des tôles, les surfaces latérales des trous pratiqués dans la couche interne pour accueillir les ponts thermiques, qui sont en parallèles aux efforts de laminage, constituent des points faibles au niveau des liaisons atomiques de sorte que la cohésion mécanique des couches est susceptible d'être réduite dans ces zones.

Il a en particulier été constaté que la liaison entre la couche d'Invar® et les couches externes en cuivre était susceptible d'être réduite dans ces zones.

La liaison entre la couche d'Invar® et les couches externes en cuivre est en particulier susceptible d'être rompue dans des zones dans lesquelles le support est destiné à être plié. L'existence des ponts thermiques constitue une singularité de contrainte à l'échelle macroscopique et la moindre qualité des soudages à l'état solide des couches interne et externes à l'échelle microscopique sur les parois des trous accentue la faiblesse locale lors d'une opération de pliage.

Or, la réalisation d'un support pour module électronique de puissance impose le plus souvent de prévoir des mises en forme, notamment des pliages du support, afin de prévoir des connexions à des sous-ensembles électromécaniques. De telles mises en forme sont notamment nécessaires pour créer des sorties ou des entrées électriques pour le module de puissance, sans devoir lier mécaniquement ou par soudure ou brasure ces entrées ou sorties qui, sinon, engendreraient des coûts supplémentaires non négligeables ainsi que des risques de discontinuité électrique.

Le but de l'invention est de pallier cet inconvénient et de proposer un support pour composants électroniques de puissance réalisé à partir d'un matériau composite multicouche colaminé, qui présente sur toute sa surface une bonne conductivité thermique et électrique et qui présente dans les zones destinées à accueillir les puces électroniques un coefficient de dilatation linéique proche de celui du silicium ou de tout autre semi-conducteur pour être utilisé sur une large gamme de températures et avoir ainsi une durée de vie bien supérieure à celle dont il dispose actuellement.

Un autre but de l'invention est de proposer un tel support qui garantisse une cohésion entre les couches du matériau multicouche.

L'invention a donc pour objet, selon un premier aspect, un support pour composants électroniques de puissance, comprenant un matériau composite multicouche colaminé ayant au moins une couche interne en matériau à coefficient de dilatation thermique choisi en fonction du coefficient de dilatation desdits composants et des couches externes en matériau conducteur de la chaleur recouvrant de part et d'autre ladite couche interne et reliées entre elles par des puits en matériau conducteur de la chaleur agencés dans la couche interne.

Chaque couche interne constitue un insert localisé dans une zone de montage des composants de sorte que les couches externes s'étendent latéralement au-delà de l'insert.

En d'autres termes, les puits thermiques qui s'étendent entre les couches externes conductrices de la chaleur à travers la couche interne à faible coefficient de dilatation thermique permettent d'évacuer la chaleur. Toutefois, le matériau à faible coefficient de dilatation thermique et les puits en matériau conducteur de la chaleur sont réalisés uniquement sous les composants électroniques de sorte que, latéralement, le colaminage des couches externes sans insert permet d'obtenir une liaison mécanique suffisamment résistante entre ces couches pour conserver l'aptitude au pliage et à la mise en forme du support.

Par exemple, le matériau de la couche interne est choisi parmi l'Invar®, les alliages Fe-Ni à dilatation limitée, le molybdène et ses alliages, le niobium et ses alliages, et le tungstène et ses alliages.

Selon une autre caractéristique du support selon l'invention, le matériau conducteur des couches externes et/ou des puits comprend au moins un métal choisi parmi le cuivre et ses alliages, l'argent et ses alliages, et l'aluminium et ses alliages.

Selon encore une autre caractéristique du support selon l'invention, au moins l'une des couches externes comprend au moins une première zone, par laquelle elle s'étend latéralement au-delà d'une couche interne, ayant une première épaisseur et au moins une deuxième zone localisée dans une zone de montage des composants ayant une deuxième épaisseur inférieure à la première épaisseur.

Par exemple, les couches externes, qui recouvrent de part et d'autre la couche interne, ont chacune des zones ayant lesdites première et deuxième épaisseurs.

En variante, l'une des couches externes, qui recouvre l'une des faces de la couche interne, présente des zones ayant lesdites première et deuxième épaisseurs, l'autre couche externe étant laminée et ayant une épaisseur constante.

Par exemple, les ponts sont périodiquement répartis dans le matériau.

On peut prévoir, par exemple, que la proportion surfacique des puits est inférieure à 35%.

L'invention a également pour objet, selon un deuxième aspect, un module de puissance comprenant un support et des composants électroniques de puissance montés sur le support dans des zones de montage des composants, le support comprenant un matériau composite multicouche colaminé ayant au moins une couche interne en matériau à coefficient de dilatation thermique choisi en fonction du coefficient de dilatation desdits composants et des couches externes en matériau conducteur de la chaleur recouvrant de part et d'autre ladite couche interne et reliées entre elles par des puits en matériau conducteur de la chaleur agencés dans la couche interne.

Chaque couche interne constitue un insert localisé uniquement dans la zone de montage des composants de sorte que les couches externes s'étendent latéralement au-delà de l'insert.

Selon une autre caractéristique de ce module de puissance, le support comprend des zones de pliage. Dans ces zones de pliage, les couches externes sont colaminées sans insert.

En d'autres termes, en dehors des zones de montage des composants, les couches externes sont colaminées sans insert.

L'invention a enfin pour objet, selon un troisième aspect, un procédé de fabrication d'un support pour composants électroniques de puissance comprenant les étapes suivantes :
- positionnement d'une première couche de matériau à coefficient de dilatation thermique choisi en fonction du coefficient de dilatation thermique des composants entre des couches externes en matériau conducteur de la chaleur de sorte que la première couche de matériau constitue un insert localisé dans une zone de montage des composants et que les couches externes soient reliées entre elles par des puits en matériau conducteur de la chaleur agencés dans la première couche et de sorte que les couches externes s'étendent latéralement au-delà de l'insert ; et
- colaminage de ladite couche interne et des couches externes par passage dans l'entrefer d'un laminoir.

D'autres buts, caractéristiques et avantages de l'invention apparaîtront à la lecture de la description suivante, donnée uniquement à titre d'exemple non limitatif, et faite en référence aux dessins annexés sur lesquels :
- la figure 1 est une vue en coupe d'un support conforme à l'invention pour module électronique de puissance ;
- la figure 2 est une vue en perspective du support de la figure 1, avec écorché partiel ;
- les figures 3 et 4 illustrent un exemple de réalisation d'un support conforme à l'invention ;
- la figure 5 montre schématiquement le support de la figure 1, après pliage ;
- les figures 6 et 7 illustrent un autre mode de réalisation d'un support conforme à l'invention ;
- la figure 8 illustre une variante de réalisation d'un support conforme à l'invention ;
- la figure 9 est un histogramme montrant la température en diverses zones d'un support conforme à l'invention et selon l'état de la technique et soumis à une sollicitation thermique sévère par les puces qu'il supporte ; et
- la figure 10 est un histogramme montrant le niveau de contrainte au sein d'un support conforme à l'invention et selon l'état de la technique.

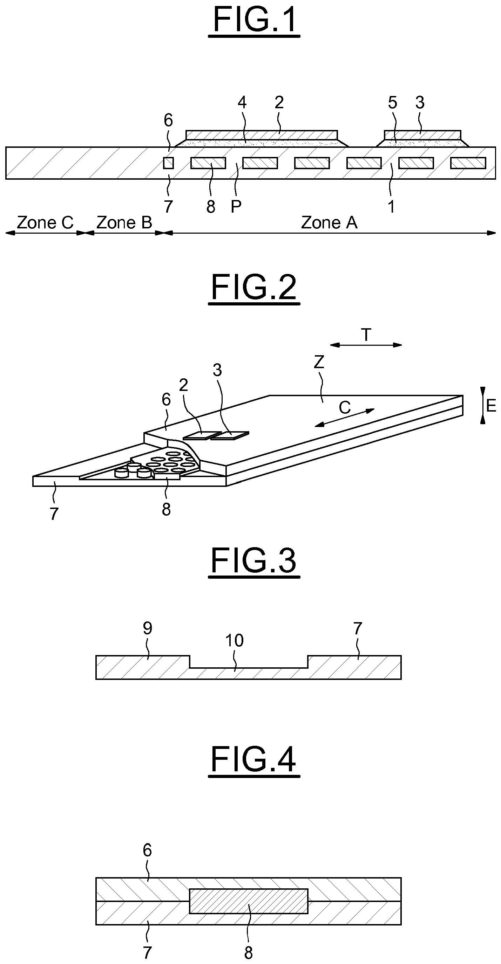

On a représenté sur la figure 1 un support conforme à l'invention, désigné par la référence numérique générale 1.

Ce support est destiné à constituer un élément d'un module électronique de puissance, par exemple un module de puissance comprenant des composants électroniques de puissance 2 et 3, par exemple un transistor et une diode, respectivement, montés sur le support 1 au moyen d'une couche de brasure 4 et 5.

Comme on le voit, le support 1 comporte deux couches externes 6 et 7, en matériau conducteur, en l'espèce du métal, disposées de part et d'autre d'une couche interne 8 en matériau à dilatabilité thermique limitée.

Les couches externes 6 et 7 sont de préférence en cuivre et confèrent ainsi une excellente conductivité thermique et électrique dans le plan de la couche et donc une répartition homogène de la chaleur et de la densité de courant.

Les couches externes 6, 7 peuvent toutefois également être réalisées, en variante, en alliage de cuivre, en argent ou en alliage d'argent ou en aluminium et ses alliages.

La couche interne 8 est, quant à elle, constituée d'une couche en matériau à dilatation thermique limitée, c'est-à-dire voisine de celle du silicium de manière à obtenir un coefficient de dilatation thermique correspondant à celui des composants 2 et 3 montés sur le support 1.

On voit toutefois que la couche interne 8 est perforée de canaux constituant des puits P de conduction rapide de la chaleur. Ces canaux sont remplis d'un matériau de très bonne conductivité thermique et constituent alors des ponts thermiques. On conçoit dès lors que le matériau emplissant les canaux remplace localement le matériau de la couche interne. En d'autres termes, le support comporte localement des ponts thermiques formés par les puits qui s'étendent entre les couches externes 6 et 7. De tels puits, avantageusement régulièrement répartis dans la couche interne 8, peuvent être obtenus par perforation de la couche interne ou par usinage, comme cela sera décrit par la suite. On notera néanmoins que, dans un mode de réalisation, la proportion surfacique des puits est avantageusement inférieure à 35%.

On réalisera avantageusement les ponts thermiques à partir du même matériau que celui utilisé pour la réalisation des couches externes.

En ce qui concerne le matériau utilisé pour la réalisation de la couche interne 8, on notera que l'on peut utiliser le molybdène, le niobium, etc., ou un alliage métallique à dilatation réduite tel que l'Invar®.

Généralement, ces matériaux possèdent une bonne aptitude à établir une liaison métallurgique avec le cuivre.

Le molybdène présente des propriétés thermomécaniques appropriées pour l'utilisation envisagée. Il s'agit en particulier d'une haute température de fusion, un module d'élasticité élevée, une résistance mécanique élevée à moyenne température, de bonne conductivités électrique et thermique, un coefficient de dilatation faible et une excellente résistance à la corrosion dans de nombreux milieux. D'autres compositions à base de Cu-Mo, telles que des colaminés (« Cu/Mo/Cu » et « Co/Mo₇₀Cu₃₀/Cu ») peuvent également être utilisées, également pour une telle application mécatronique comme support pour module de puissance.

Alternativement, comme indiqué précédemment, il est possible d'utiliser l'Invar® pour la réalisation de la couche interne. Il s'agit d'un alliage FeNi_{(36%)} associé à une très faible dilatabilité thermique sur une très large plage de températures allant d'environ -100°C à +100°C. Cet alliage est utilisé non seulement pour cette propriété particulière mais aussi pour ses caractéristiques mécaniques.

Toutefois, comme le montre les figures 1 et 2, et notamment la figure 2 sur laquelle C, E et T désignent respectivement la direction de colaminage, l'épaisseur du support et la direction transversale du support, la couche interne est localisée à l'endroit d'une zone Z de montage des composants 2 et 3. Cette couche interne constitue dès lors un insert localisé uniquement dans cette zone de sorte que, latéralement, c'est-à-dire de chaque côté de la zone de montage des composants 2 et 3, le support ne comporte que les deux couches externes colaminées et présentant dès lors des liaisons atomiques suffisamment fortes pour permettre le pliage du support.

En se référant maintenant aux figures 3 et 4, le support qui vient d'être décrit est réalisé par colaminage des couches externes 6 et 7 et de la couche interne 8 localisée.

On forme tout d'abord les couches externes 6 ou 7 de manière à obtenir une couche présentant deux épaisseurs, c'est-à-dire comprenant une première zone latérale 9, ayant une première épaisseur, qui est destinée à s'étendre latéralement au-delà de la couche interne, et une zone 10 ayant une deuxième épaisseur inférieure à la première épaisseur et destinée à recevoir la couche interne 8.

Il peut s'agir de mettre en œuvre une étape d'enlèvement de matière, par exemple par fraisage ou de procéder à un martelage et/ou un laminage à l'endroit de la deuxième zone 10.

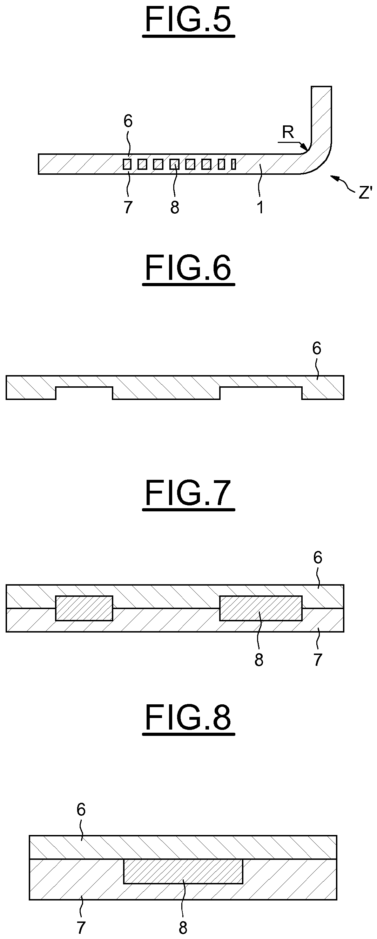

Les couches 6 et 7 sont alors placées en vis-à-vis, avec interposition d'une couche interne 8, puis on procède à un colaminage de l'ensemble de manière à obtenir de part et d'autre de la zone à ponts thermiques une zone réalisée uniquement à partir de couches de cuivre colaminées autorisant dès lors un pliage du support et en particulier un pliage du support selon un faible rayon R sans endommagement de la soudure à l'état solide réalisée par colaminage (figure 5).

Dans l'exemple de réalisation décrit en référence aux figures 3 et 4, le support comporte un unique insert 8. Bien entendu, on ne sort pas du cadre de l'invention lorsque le support comporte un ensemble de tels inserts (figures 6 et 7).

De même, en se référant à la figure 8, sur laquelle des éléments identiques à ceux des figures 3 et 4 portent les même références, il est également possible de réaliser un support à partir d'une couche externe comprenant les deux zones 9 et 10 ayant des épaisseurs différentes de manière à former des empreintes pouvant recevoir un insert en matériau à coefficient de dilatation thermique choisi en fonction du coefficient de dilatation des composants électroniques, et une couche opposée 7 réalisée par laminage et ayant une épaisseur constante.

Comme cela a été décrit précédemment, la réalisation d'un support pour composants électroniques de puissance ayant une couche interne dotée de ponts thermiques et localisée à l'endroit de la zone de montage des composants permet d'obtenir une bonne conductivité thermique et électrique et un coefficient de dilatation linéique proche de celui des composants. En outre, dans la zone Z' dans laquelle le support est destiné à être plié, le support est dépourvu d'insert de sorte que les couches externes sont colaminées, ce qui permet d'obtenir des liaisons atomiques suffisantes pour autoriser un pliage du support.

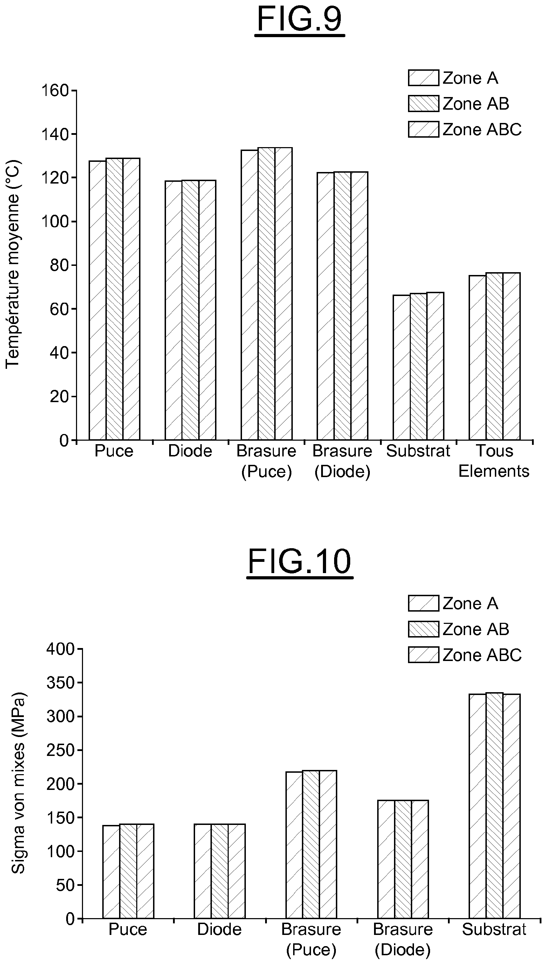

On a représenté sur la figure 9 l'évolution de la température moyenne à différents endroits du support de la figure 1, notamment à l'endroit de la puce de transistor 2, de la diode 3, au niveau de la brasure 4 de la puce 2, au niveau de la brasure 5 de la diode 3, au niveau du support 1 et pour l'ensemble de ces éléments. Sur cet histogramme, on a représenté les valeurs de température au niveau de la zone A de la figure 1, c'est à dire sous les composants, les valeurs de température de la zone B, au voisinage de la zone A et les valeurs de température d'une zone C décalée latéralement de la zone B.

On constate que limiter le matériau à faible dilatation sous les composants ne modifie pas le comportement thermique du support.

De même, la figure 10, qui illustre l'évolution de la contrainte Sigma von Mises dans les zones A, B et C du substrat, montre qu'aucune modification sensible du comportement mécanique du substrat n'est engendrée en localisant les matériaux à faible dilatation sous les composants électroniques.

## Revendications

1. Support pour composants électroniques de puissance, comprenant un matériau composite multicouche colaminé ayant au moins une couche interne (8) en matériau à coefficient de dilatation thermique choisi en fonction du coefficient de dilatation desdits composants et des couches externes (6, 7) en matériau conducteur de la chaleur recouvrant de part et d'autre ladite couche interne et reliées entre elles par des puits (P) en matériau conducteur de la chaleur agencés dans la couche interne, chaque couche interne constitue un insert localisé uniquement dans une zone de montage des composants de sorte que les couches externes s'étendent latéralement au-delà de l'insert.

2. Support selon la revendication 1, dans lequel le matériau de la couche interne est choisi dans le groupe comprenant l'Invar®, les alliages Fe-Ni à dilatation limitée, le molybdène et ses alliages, le niobium et ses alliages, et le tungstène et ses alliages.

3. Support selon l'une des revendications 1 et 2, dans lequel le matériau conducteur des couches externes et/ou des puits comprend au moins un métal choisi parmi le cuivre et ses alliages, l'argent et ses alliages, et l'aluminium et ses alliages.

4. Support selon l'une quelconque des revendications 1 à 3, dans lequel au moins l'une des couches externes comprend au moins une première zone par laquelle elle s'étend latéralement au-delà d'une couche interne, ayant une première épaisseur et au moins une deuxième zone localisée dans une zone de montage du composant ayant une deuxième épaisseur inférieure à la première épaisseur.

5. Support selon la revendication 4, dans lequel les couches externes qui recouvrent de part et d'autre la couche interne ont chacune des zones ayant lesdites première et deuxième épaisseurs.

6. Support selon la revendication 4, comprenant une couche externe qui recouvre l'une des faces de la couche interne et qui présente des zones ayant lesdites première et deuxième épaisseurs et une couche externe laminée ayant une épaisseur constante.

7. Support selon l'une quelconque des revendications 1 à 6, dans lequel les puits sont périodiquement répartis dans le matériau.

8. Support selon l'une quelconque des revendications 1 à 7, dans lequel la proportion surfacique des puits est inférieure à 35%.

9. Module de puissance comprenant un support (1) selon la revendication 1 et des composants électroniques de puissance (2, 3) montés sur le support dans des zones (Z) de montage des composants.

10. Module selon la revendication 9, dans lequel le support comprend des zones de pliage (Z') et dans lequel dans lesdites zones de pliage, les couches externes sont colaminées.

11. Module selon l'une des revendications 9 et 10, dans lequel, en dehors des zones de montage des composants, les couches externes sont colaminées.

12. Procédé de fabrication d'un support pour composants électroniques de puissance, **caractérisé en ce qu'**il comporte les étapes suivantes :
- positionnement d'une première couche (8) de matériau à coefficient de dilatation thermique choisi en fonction du coefficient de dilatation thermique des composants entre des couches externes (6, 7) en matériau conducteur de la chaleur de sorte que la première couche de matériau constitue un insert localisé uniquement dans une zone (Z) de montage des composants et que les couches externes soient reliées entre elles par des puits en matériau conducteur de la chaleur agencés dans la première couche et de sorte que les couches externes s'étendent latéralement au-delà de l'insert ; et
- colaminage de ladite couche interne et des couches externes par passage dans l'entrefer d'un laminoir.

## Patentansprüche

1. Träger für elektronische Leistungskomponenten, der ein mehrschichtiges kolaminiertes Verbundmaterial beinhaltet, mit mindestens einer Innenschicht (8) aus einem Material mit einem Wärmeausdehnungskoeffizienten, das in Abhängigkeit vom Ausdehnungskoeffizienten der Komponenten gewählt wird, und Außenschichten (6, 7) aus einem wärmeleitenden Material, welches beide Seiten der Innenschicht bedeckt und durch Senken (P) aus wärmeleitendem Material miteinander verbunden sind, die in der Innenschicht angeordnet sind, jede Innenschicht bildet einen Einsatz, der sich nur in einem Montagebereich der Komponenten befindet, so dass die Außenschichten sich seitlich über den Einsatz hinaus erstrecken.

2. Träger nach Anspruch 1, wobei das Material der Innenschicht in der Gruppe mit dem Invar®, den Fe-Ni-Legierungen mit begrenzter Ausdehnung, dem Molybdän und seinen Legierungen, dem Niob und seinen Legierungen, und dem Wolfram und seinen Legierungen, gewählt wird.

3. Träger nach einem der Ansprüche 1 und 2, wobei das leitende Material der Außenschichten und/oder der Senken mindestens ein Metall, ausgewählt aus Kupfer und seinen Legierungen, Silber und seinen Legierungen und Aluminium und seinen Legierungen, beinhaltet.

4. Träger nach einem der Ansprüche 1 bis 3, wobei mindestens eine der Außenschichten mindestens einen ersten Bereich beinhaltet, durch den sie sich seitlich über eine Innenschicht hinaus erstreckt, mit einer ersten Dicke und mindestens einem zweiten Bereich, der sich in einem Montagebereich der Komponente befindet, mit einer zweiten Dicke, die geringer ist als die erste Dicke.

5. Träger nach Anspruch 4, wobei die Außenschichten, die die Innenschicht auf beiden Seiten bedecken, jeweils einen der Bereiche mit der ersten und zweiten Dicke aufweisen.

6. Träger nach Anspruch 4, der eine Außenschicht beinhaltet, die eine der Seiten der Innenschicht bedeckt und die Bereiche mit den ersten und zweiten Dicken und eine laminierte Außenschicht mit einer konstanten Dicke aufweist.

7. Träger nach einem der Ansprüche 1 bis 6, wobei die Senken periodisch in dem Material angeordnet sind.

8. Träger nach einem der Ansprüche 1 bis 7, wobei der Flächenanteil der Senken niedriger als 35 % ist.

9. Leistungsmodul mit einem Träger (1) nach Anspruch 1 und den elektronischen Leistungskomponenten (2, 3), die auf dem Träger in den Montagebereichen (Z) der Komponenten angebracht werden.

10. Modul nach Anspruch 9, wobei der Träger Faltbereiche (Z') besitzt und wobei die Außenschichten in den Faltbereichen kolaminiert sind.

11. Modul nach einem der Ansprüche 9 und 10, wobei die Außenschichten außerhalb der Montagebereiche der Komponenten kolaminiert sind.

12. Herstellungsverfahren eines Trägers für elektronische Leistungskomponenten, **dadurch gekennzeichnet, dass** es folgende Schritte beinhaltet:
- Positionieren einer ersten Materialschicht (8) mit einem Wärmeausdehnungskoeffizienten, der in Abhängigkeit vom Wärmeausdehnungskoeffizienten der Komponenten gewählt wird, zwischen Außenschichten (6, 7) aus wärmeleitendem Material derart, dass die erste Materialschicht nur in einem Montagebereich (Z) der Komponenten einen lokalisierten Einsatz bildet und dass die Außenschichten durch in der ersten Schicht angeordnete Senken aus wärmeleitendem Material miteinander verbunden sind und derart, dass die Außenschichten sich seitlich über den Einsatz hinaus erstrecken; und
- Laminieren der Innenschicht und der Außenschichten durch Durchführen durch den Luftspalt eines Walzwerks.

## Claims

1. A support for power electronic components, comprising a co-laminated multilayer composite material having at least one inner layer (8) made of a material with a thermal expansion coefficient selected according to the expansion coefficient of said components and outer layers (6, 7) made of a heat conductive material covering on either side said inner layer and interconnected by wells (P) made of a heat conductive material arranged in the inner layer, each inner layer constitutes an insert located only in one area for mounting the components so that the outer layers extend laterally beyond the insert.

2. The support according to claim 1, wherein the material of the inner layer is selected from the group comprising Invar@, Fe-Ni alloys with limited expansion, molybdenum and its alloys, niobium and its alloys, and tungsten and its alloys.

3. The support according to one of claims 1 and 2, wherein the conductive material of the outer layers and/or of the wells comprises at least one metal selected from copper and its alloys, silver and its alloys, and aluminium and its alloys.

4. The support according to any one of claims 1 to 3, wherein at least one of the outer layers comprises at least a first area through which it extends laterally beyond an inner layer, having a first thickness and at least a second area located in an area for mounting the components having a second thickness less than the first thickness.

5. The support according to claim 4, wherein the outer layers which cover on either side the inner layer each have areas having said first and second thicknesses.

6. The support according to claim 4, comprising an outer layer which covers one of the faces of the inner layer and which has areas having said first and second thicknesses and a laminated outer layer having a constant thickness.

7. The support according to any one of claims 1 to 6, wherein the wells are periodically distributed in the material.

8. The support according to any one of claims 1 to 7, wherein the surface proportion of the wells is less than 35%.

9. A power module comprising a support (1) according to claim 1 and electronic power components (2, 3) mounted on the support in areas (Z) for mounting the components.

10. The module according to claim 9, wherein the support comprises folding areas (Z') and wherein the outer layers are co-laminated in said folding areas.

11. The module according to one of claims 9 and 10, wherein the outer layers are co-laminated outside the areas for mounting the components.

12. A method for manufacturing a support for power electronic components, **characterised in that** it comprises the following steps:
- positioning a first layer (8) made of a material with a thermal expansion coefficient selected according to the thermal expansion coefficient of the components between outer layers (6, 7) made of a heat conductive material so that the first layer of material constitutes an insert located only in one area (Z) for mounting the components and that the outer layers are interconnected by wells made of a heat conductive material arranged in the first layer and so that the outer layers extend laterally beyond the insert; and
- co-laminating said inner layer and outer layers by passing through the air gap of a rolling mill.
